# EUROPEAN PATENT APPLICATION

(11) **EP 2 824 821 A1**
(43) Date of publication of application: **14.01.2015**
(21) Application number: 13757512.2
(22) Date of filing: 27.02.2013
(51) Int. Cl.: H02M 7/48

(54) **POWER CONVERSION APPARATUS**

(30) Priority: 07.03.2012 JP 2012050627
(71) Applicant: Nissan Motor Co., Ltd, Yokohama-shi, Kanagawa 221-0023 (JP)
(72) Inventor: NAKAYAMA, Hiroyuki, Atsugi-shi Kanagawa 243-0123 (JP); NAGAI, Yoshiyuki, Atsugi-shi Kanagawa 243-0123 (JP)
(74) Representative: Grünecker, Kinkeldey, Stockmair & Schwanhäusser
(86) International application number: PCT/JP2013/055144
(87) International publication number: WO 2013/133104

(57) **Abstract**

Provided is a power conversion apparatus, including: a power module; a base section including a cooler; a second substrate; a first bus bar; a second bus bar; a smoothing capacitor; and a first substrate. The power module is placed on an upper surface of the base section. The first bus bar, the smoothing capacitor, and the first substrate are sequentially stacked on an upper side of the power module. The second substrate is arranged in an upright direction with respect to the base section and is fixed to the power module and the first substrate.

## Description

### TECHNICAL FIELD

This invention relates to a power conversion apparatus for converting electricity by a semiconductor element.

### BACKGROUND ART

A power conversion apparatus, which is used for inverter control of an electric motor or the like, includes a power semiconductor such as a switching element, and a control circuit for controlling operation of the power semiconductor device. The power semiconductor generates much heat, and hence it is necessary to construct so that the control circuit is free from being affected by the heat.

As the power conversion apparatus described above, JP4609504B discloses an apparatus in which, with respect to a first circuit substrate on which a power semiconductor element is mounted, a second circuit substrate on which a circuit component for controlling the power semiconductor element is mounted is arranged perpendicularly, and one end of the second circuit substrate is electrically connected to the first circuit substrate.

### SUMMARY OF INVENTION

In the power conversion apparatus having the structure described in JP 4609504 B, the first circuit substrate on which the power semiconductor element is mounted is connected to the second circuit substrate only at the one end thereof. Therefore, because of external stress such as vibration and impact, stress may occur between the first circuit substrate and the second circuit substrate. This stress may cause a problem in that durability and reliability of the power conversion apparatus are deteriorated.

The present invention was developed in view of such a problem and aims to provide a power conversion apparatus including a power semiconductor element in which durability can be improved.

One aspect of the present invention is applied to a power conversion apparatus, including: a power module including a power semiconductor; a base section including a cooler for cooling the power module; a control substrate, on which a control circuit for controlling the power module is mounted; a first bus bar for supplying power to the power module; a second bus bar for outputting power from the power module; a smoothing capacitor for smoothing power of the first bus bar; and a first substrate including a signal wiring.

Embodiments and advantages of the present invention are described in detail below with reference to the accompanying drawings.

### BRIEF DESCRIPTION OF DRAWINGS

FIG. 1 is an explanatory diagram of a drive system including a semiconductor module according to a first embodiment of this invention.
FIG. 2A is an explanatory diagram of a power conversion apparatus according to the first embodiment of this invention.
FIG. 2B is an explanatory diagram of the power conversion apparatus according to the first embodiment of this invention.
FIG. 3A is an explanatory diagram of the power conversion apparatus according to the first embodiment of this invention and is a cross-sectional view of FIG. 2A.
FIG. 3B is an explanatory diagram of the power conversion apparatus according to the first embodiment of this invention and is a cross-sectional view of FIG. 2A.
FIG. 4 is an explanatory diagram of a power conversion apparatus according to a second embodiment of this invention.
FIG. 5A is an explanatory diagram of the power conversion apparatus according to the second embodiment of this invention and is a cross-sectional view of FIG. 4.
FIG. 5B is an explanatory diagram of the power conversion apparatus according to the second embodiment of this invention and is a cross-sectional view of FIG. 4.
FIG. 6 is an explanatory diagram of a power conversion apparatus according to a third embodiment of this invention.
FIG. 7A is an explanatory diagram of the power conversion apparatus according to the third embodiment of this invention and is a cross-sectional view of FIG. 6.
FIG. 7B is an explanatory diagram of the power conversion apparatus according to the third embodiment of this invention and is a cross-sectional view of FIG. 6.
FIG. 8 is an explanatory diagram of a power conversion apparatus according to a fourth embodiment of this invention.
FIG. 9A is an explanatory diagram of the power conversion apparatus according to the fourth embodiment of this invention and is a cross-sectional view of FIG. 8.
FIG. 9B is an explanatory diagram of the power conversion apparatus according to the fourth embodiment of this invention and is a cross-sectional view of FIG. 8.
FIG. 10 is an explanatory diagram of a power conversion apparatus according to a fifth embodiment of this invention.
FIG. 11A is an explanatory diagram of the power conversion apparatus according to the fifth embodiment of this invention and is a cross-sectional view of FIG. 10.
FIG. 11B is an explanatory diagram of the power conversion apparatus according to the fifth embodiment of this invention and is a cross-sectional view of FIG. 10.
FIG. 12 is an explanatory diagram of a power conversion apparatus according to a sixth embodiment of this invention.
FIG. 13A is an explanatory diagram of the power conversion apparatus according to the sixth embodiment of this invention and is a cross-sectional view of FIG. 12.
FIG. 13B is an explanatory diagram of the power conversion apparatus according to the sixth embodiment of this invention and is a cross-sectional view of FIG. 12.
FIG. 14 is an explanatory diagram of a power conversion apparatus according to a seventh embodiment of this invention.
FIG. 15A is an explanatory diagram of the power conversion apparatus according to the seventh embodiment of this invention and is a cross-sectional view of FIG. 14.
FIG. 15B is an explanatory diagram of the power conversion apparatus according to the seventh embodiment of this invention and is a cross-sectional view of FIG. 14.
FIG. 16 is an explanatory diagram of a power conversion apparatus according to an eighth embodiment of this invention.
FIG. 17A is an explanatory diagram of the power conversion apparatus according to the eighth embodiment of this invention and is a cross-sectional view of FIG. 16.
FIG. 17B is an explanatory diagram of the power conversion apparatus according to the eighth embodiment of this invention and is a cross-sectional view of FIG. 16.
FIG. 18 is an explanatory diagram of a power conversion apparatus according to a ninth embodiment of this invention.
FIG. 19A is an explanatory diagram of the power conversion apparatus according to the ninth embodiment of this invention and is a cross-sectional view of FIG. 18.
FIG. 19B is an explanatory diagram of the power conversion apparatus according to the ninth embodiment of this invention and is a cross-sectional view of FIG. 18.

### DESCRIPTION OF EMBODIMENTS

Embodiments of this invention are described with reference to the drawings.

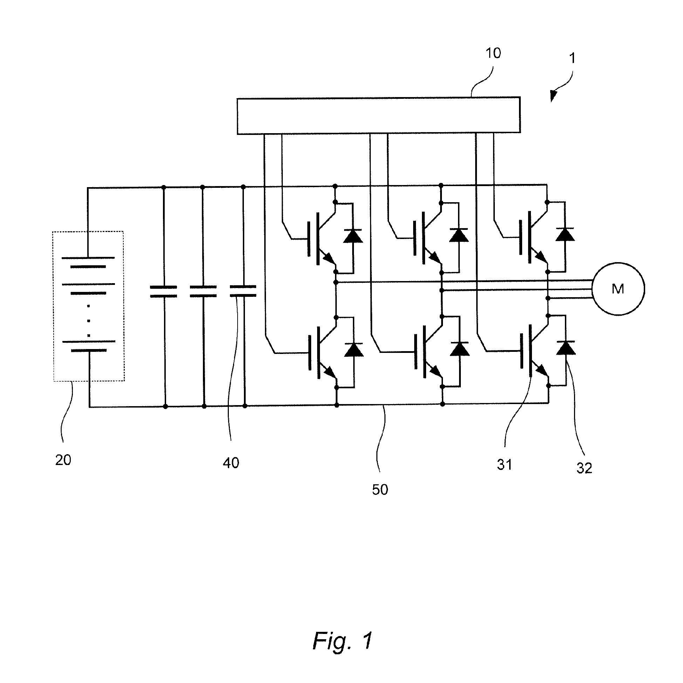

FIG. 1 is an explanatory diagram of a drive system 1 according to a first embodiment of this invention.

The drive system 1 includes a power conversion apparatus 50, a battery 20, and a driving motor M. The power conversion apparatus 50 includes a control circuit 10, a power semiconductor 31, a diode 32, a smoothing capacitor 40, and the like. The control circuit 10 controls an output of the power semiconductor 31 so as to control the driving motor M.

The battery 20 supplies electric power to the driving motor M and stores regenerative electric power from the driving motor M. The battery 20 is formed as a battery module, in which a plurality of secondary batteries, such as lead-acid batteries, nickel-hydrogen batteries, or lithium-ion batteries, are connected in series or in parallel.

The power semiconductor 31 is formed of a semiconductor element such as an IGBT. The diode 32 is formed of a semiconductor element such as a fast recovery diode (FRD). The diode 32 prevents reverse current from being applied to the power semiconductor 31 so as to protect the power semiconductor 31. The smoothing capacitor 40 smoothes power output from the power semiconductor 31.

When increasing an output of the driving motor M, for example, the control circuit 10 applies gate current to each power semiconductor 31. Thus, high current from the battery 20 is supplied to the driving motor M.

The control circuit 10 controls the gate current by a duty ratio or the like so as to control the output of the driving motor M. When the driving motor M regenerates power, the power is stored in the battery 20 via the power conversion apparatus 50.

Next, a structure of the power conversion apparatus 50 according to the first embodiment of this invention is described.

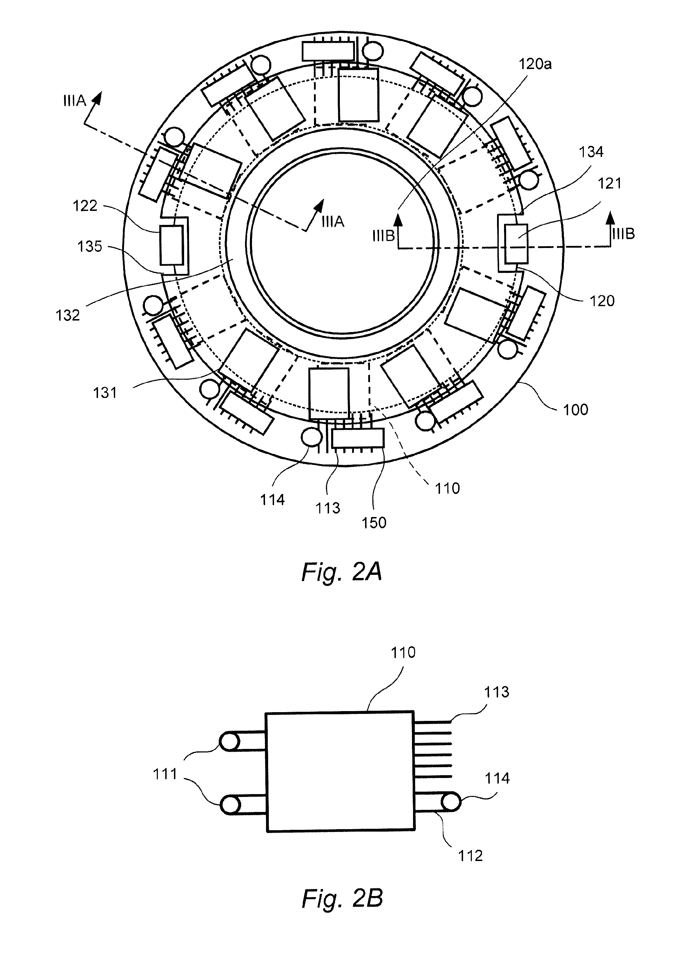

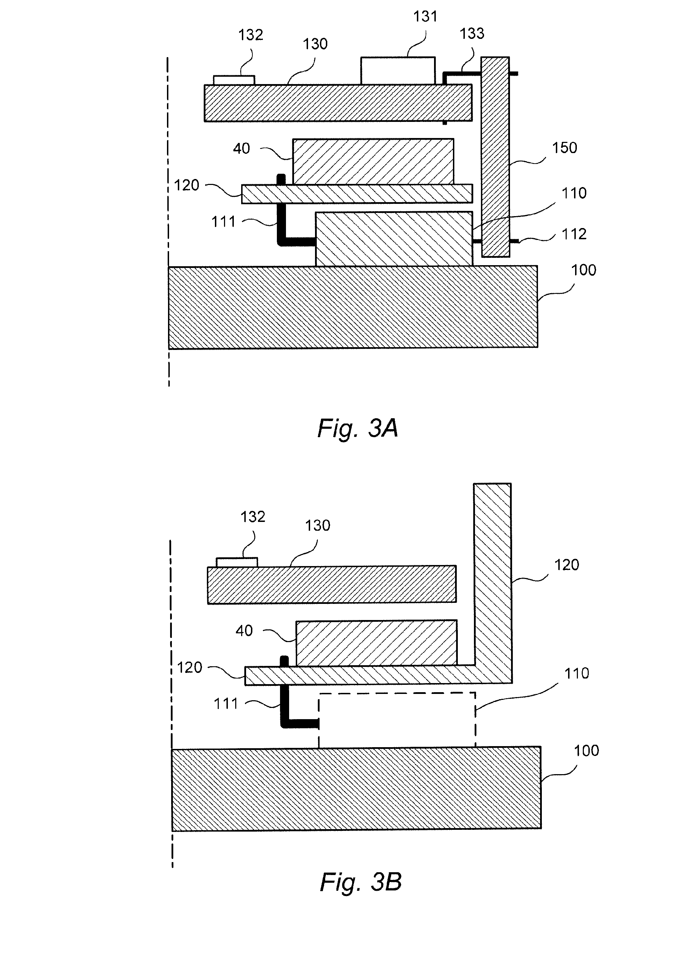

FIG. 2A, FIG. 2B, FIG. 3A, and FIG. 3B are explanatory diagrams of the power conversion apparatus 50 according to the first embodiment of this invention. FIG. 2A is a top view of the power conversion apparatus 50. FIG. 2B illustrates a structure of a power module 110. FIG. 3A is a cross-sectional view of the power conversion apparatus 50 taken along the line IIIA-IIIA in FIG. 2A. FIG. 3B is a cross-sectional view of the power conversion apparatus 50 taken along the line IIIB-IIIB in FIG. 2A.

The power conversion apparatus 50 includes a cooler 100 as a base section having a cylindrical shape and a flat top on the upper surface, and individual members stacked and arranged on the top side of the cooler 100.

The power conversion apparatus 50 is arranged on, for example, one end side in an axial direction of the driving motor M having a cylindrical shape in the same manner. The cooler 100 and other members are not necessarily required to have a circular outer periphery shape and may have a polygonal outer periphery shape.

On the top of the cooler 100, a plurality of the power modules 110 are placed along the circular shape of the top at a predetermined interval in the circumferential direction. The power module 110 is a module package including the power semiconductor 31, the diode 32, and the like encapsulated in the same package. In this embodiment, ten power modules 110 are placed on the top of the cooler 100.

The power module 110 includes PN terminals 111 for receiving high voltage DC power supply, an AC terminal 112 for outputting AC high frequency power, and a plurality of control signal terminals 113 connected to a control substrate 150 described later.

The power module 110 is placed on the top of the cooler 100 so that the PN terminals 111 face an inner circumferential side while the AC terminal 112 and the control signal terminals 113 face an outer circumferential side. The AC terminal 112 is provided with an AC bus bar 114 directed toward the outer circumferential side of the cooler 100 and extending upward of the cooler 100. The AC bus bar 114 is electrically connected to the driving motor M.

On the upper side of the power module 110, there is arranged a DC bus bar 120 for supplying DC power to the power module 110. The DC bus bar 120 has an annular shape along the shape of the top of the cooler 100. The DC bus bar 120 includes a positive electrode and a negative electrode. The positive electrode and the negative electrode are respectively connected to the PN terminals of the power module 110.

A set of pins 121 and 122 are arranged at two positions of the DC bus bar 120 on the outside in the circumferential direction so as to extend upward and be connected to the positive electrode and the negative electrode.

On the upper surface of the DC bus bar 120, a plurality of the smoothing capacitors 40 are placed at a predetermined interval in the circumferential direction. Each of the smoothing capacitors 40 is electrically connected to the positive electrode and the negative electrode of the DC bus bar 120.

At a position further above the DC bus bar 120, there is arranged a first substrate 130 having substantially the same annular shape as the DC bus bar 120. On the first substrate 130, light electrical components such as a current sensor 131 and a pad 132 are mounted so as to form a light electrical substrate. Cutout portions 135 and 136 are formed in the first substrate 130 so as to avoid contact with the pins 121 and 122 extending upward of the DC bus bar 120.

A circular hollow portion 120a is formed in the inner circumferential side of the DC bus bar 120 and the first substrate 130.

The current sensor 131 detects current output from the AC bus bar 114 of the power module 110. The current sensor 131 is formed of a Hall element, for example, and detects current of the AC bus bar 114 based on magnetic flux change of the AC bus bar 114 extending upward.

The pad 132 is arranged in an annular shape on the inner circumferential side of the first substrate 130 and works as a connecting portion for connecting to a connection wiring electrically connected to the driving motor M (not shown). The pad 132 is electrically connected to a controller of the driving motor M via a cable, for example, so as to input thereto values of power to be input to the driving motor M, a rotation speed, temperature, and the like.

On the outer circumferential side of each of the plurality of power modules 110 placed on the cooler 100, the control substrate 150 (second substrate) is arranged. The control substrate 150 includes the control circuit 10 and controls operation of the power semiconductor 31 of the power module 110.

The control substrate 150 is arranged in the vertical direction from the top of the cooler 100. The lower side of the control substrate 150 is connected to the control signal terminals 113 of the power module 110. The upper side of the control substrate 150 is connected to signal terminals 133 of the first substrate 130. Therefore, the lower side of the control substrate 150 is supported by the control signal terminals 113 of the power module 110, and the upper side of the control substrate 150 is supported by the signal terminals 133 of the first substrate 130.

As described above, in the first embodiment of this invention, the power conversion apparatus 50 includes the power module 110 placed on the upper surface of the cooler 100 serving as the base section. On the upper side of the power module 110, the DC bus bar 120 and the first substrate 130 serving as the light electrical substrate are sequentially stacked. Further, the control substrate 150 is fixed and electrically connected to the power modules 110 and the first substrate 130.

With this structure, the control substrate 150 is fixed at two positions on the upper and lower sides of the power module 110 and the first substrate 130, and therefore durability reliability of the control substrate 150 against external stress such as vibration or impact can be improved.

In addition, the control substrate 150 is arranged perpendicularly to the arranging direction of the power modules 110 including the power semiconductor 31, and hence influence of noise or heat of the power modules 110 can be suppressed.

In addition, the first substrate 130 serving as the light electrical substrate on which the light electrical devices such as the current sensor 131 and the pad 132 are mounted is separated from the power module 110 and the control substrate 150, and hence influence of noise or heat on the light electrical devices can be suppressed.

In addition, the smoothing capacitor 40 mounted on the DC bus bar 120 is arranged between the power module 110 and the first substrate 130 serving as the light electrical substrate, and therefore influence of noise or heat on the light electrical devices can be suppressed.

In addition, the pad 132 connected to a signal line for sending and receiving a signal to and from the driving motor M is arranged on the inner circumferential side of the first substrate 130, and the AC bus bar 114 from which a high frequency high voltage of the power module 110 is output is arranged on the outer circumferential side of the first substrate 130. With this structure, influence of noise or heat of the AC bus bar 114 on the signal line can be suppressed. Further, signal lines can be arranged in a concentrated manner on the upper side of the power conversion apparatus 50, and hence workability in connection to the driving motor M can be improved.

Next, a power conversion apparatus 50 according to a second embodiment of this invention is described.

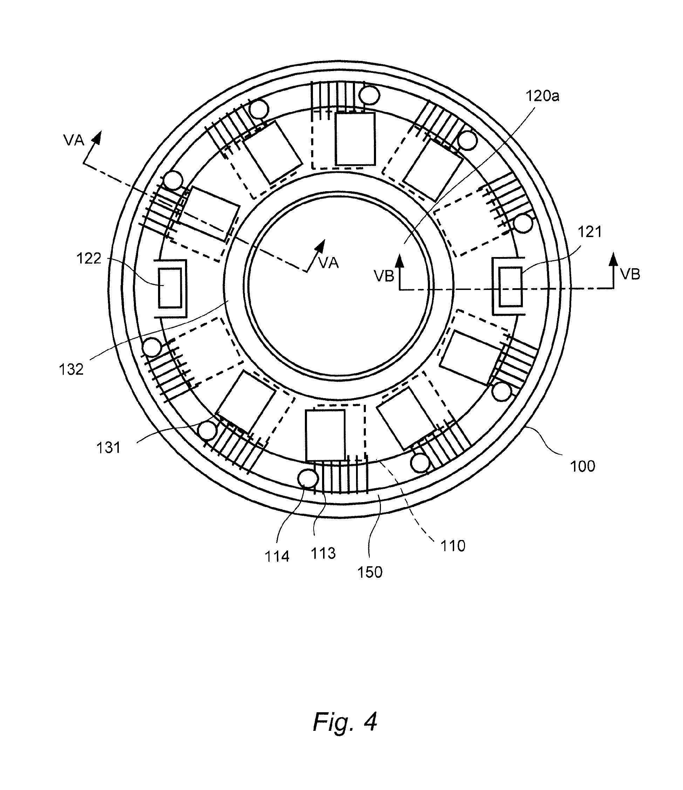

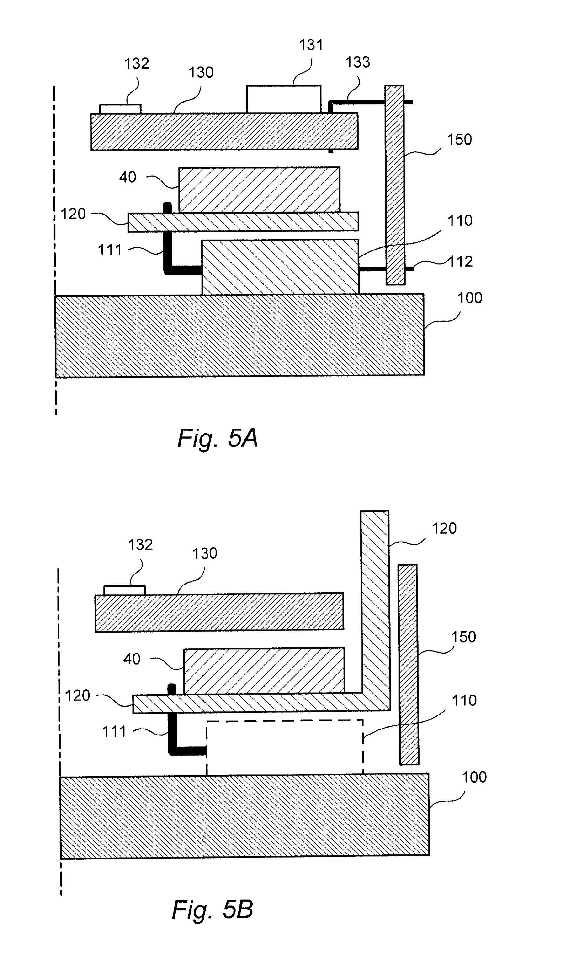

FIG. 4, FIG. 5A, and FIG. 5B are explanatory diagrams of the power conversion apparatus 50 according to the second embodiment of this invention. FIG. 4 is a top view of the power conversion apparatus 50. FIG. 5A is a cross-sectional view of the power conversion apparatus 50 taken along the line VA-VA in FIG. 4. FIG. 5B is a cross-sectional view of the power conversion apparatus 50 taken along the line VB-VB in FIG. 4.

Further, a basic structure of the second embodiment is the same as that of the first embodiment, and the same element as in the first embodiment is denoted by the same reference symbol so that overlapping description is omitted.

In the second embodiment, the control substrate 150 on which the control circuit 10 is mounted is formed of a flexible substrate, and the control substrate 150 is arranged on the outer circumferential side of the power module 110 and the first substrate 130 in a cylindrical manner.

With this structure, in the power conversion apparatus 50, the control substrate 150 can be formed into an integral shape and is fixed at two positions on the upper and lower sides of the power module 110 and the first substrate 130. Therefore, durability reliability of the control substrate 150 against external stress such as vibration or impact can be improved.

Next, a power conversion apparatus 50 according to a third embodiment of this invention is described.

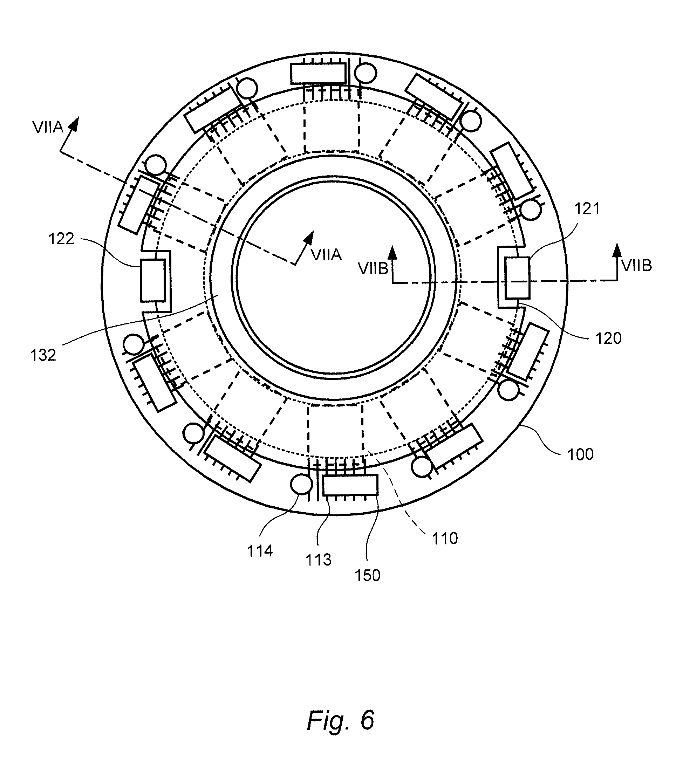

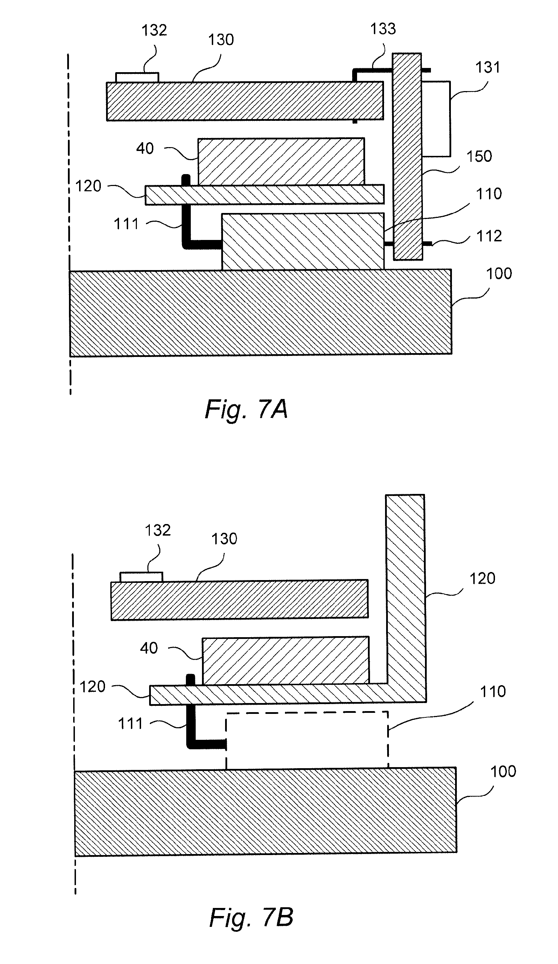

FIG. 6, FIG. 7A, and FIG. 7B are explanatory diagrams of the power conversion apparatus 50 according to the third embodiment of this invention. FIG. 6 is a top view of the power conversion apparatus 50. FIG. 7A is a cross-sectional view of the power conversion apparatus 50 taken along the line VIIA-VIIA in FIG. 6. FIG. 7B is a cross-sectional view of the power conversion apparatus 50 taken along the line VIIB-VIIB in FIG. 6.

Further, a basic structure of the third embodiment is the same as that of the first embodiment, and the same element as in the first or second embodiment is denoted by the same reference symbol so that overlapping description is omitted.

In the third embodiment, the current sensor 131 for detecting current of the AC bus bar 114 is mounted on the control substrate 150 on which the control circuit 10 is mounted.

In this way, in the third embodiment of this invention, the current sensor 131 for detecting current of the AC bus bar 114 is mounted on the control substrate 150 side, and hence the AC bus bar 114 and the current sensor 131 can be arranged closer to each other. Therefore, it is possible to prevent a detection value from being varied due to influence of vibration or the like.

In addition, the AC bus bar 114 and the first substrate 130 serving as the light electrical substrate can be separated from each other, and hence the first substrate 130 is hardly affected by the high frequency high voltage of the AC bus bar 114.

Next, a power conversion apparatus 50 according to a fourth embodiment of this invention is described.

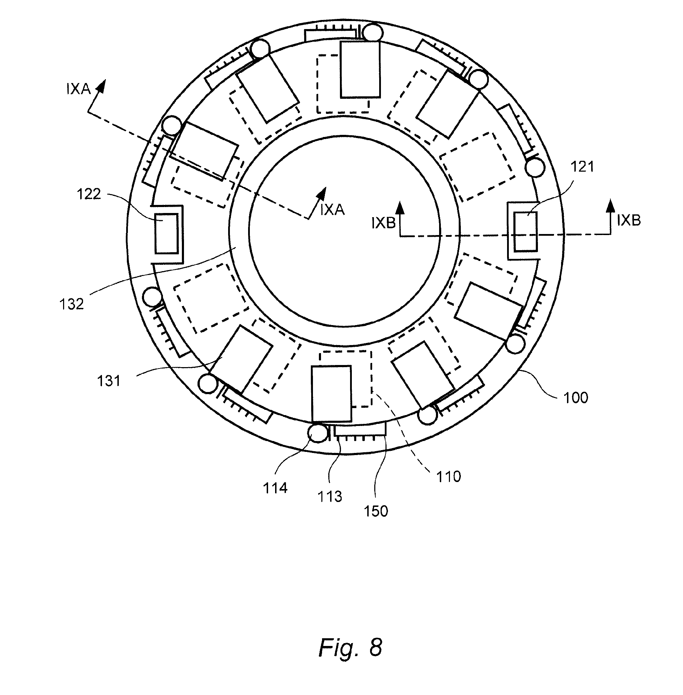

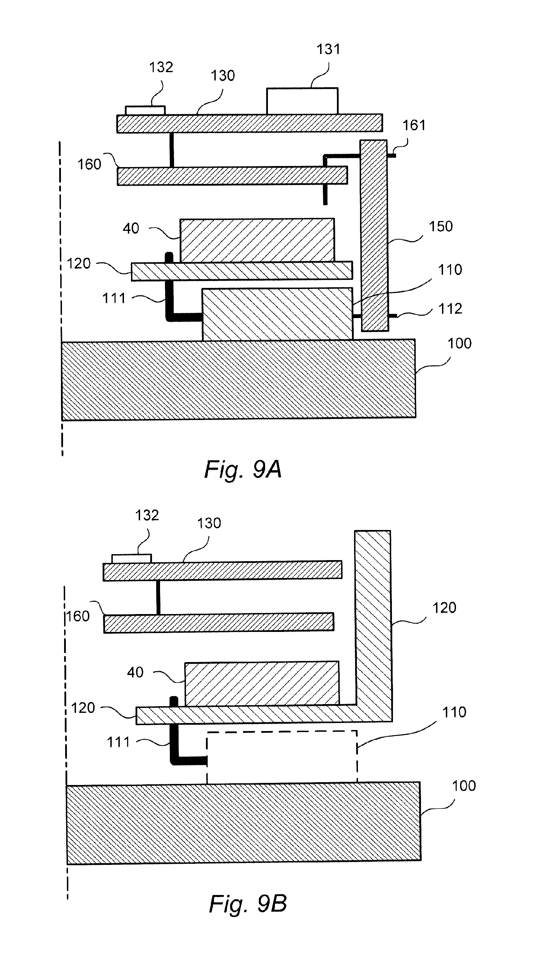

FIG. 8, FIG. 9A, and FIG. 9B are explanatory diagrams of the power conversion apparatus 50 according to the fourth embodiment of this invention. FIG. 8 is a top view of the power conversion apparatus 50. FIG. 9A is a cross-sectional view of the power conversion apparatus 50 taken along the line IXA-IXA in FIG. 8. FIG. 9B is a cross-sectional view of the power conversion apparatus 50 taken along the line IXB-IXB in FIG. 8.

Further, a basic structure of the fourth embodiment is the same as that of the first embodiment, and the same element as in the first to third embodiments is denoted by the same reference symbol so that overlapping description is omitted.

In the fourth embodiment, in addition to the substrate 130 on which the current sensor 131 and the pad 132 are mounted, there is further arranged a third substrate 160 having a signal wiring for connecting signals from the current sensor 131 and the pad 132 to the control substrate 150.

More specifically, the current sensor 131 and the pad 132 are mounted on the first substrate 130, the signal lines thereof are wired on the third substrate 160, and a signal terminal 161 connected to the third substrate 160 is connected to the control substrate 150.

In the fourth embodiment, in this way, the first substrate 130 serving as the light electrical substrate and the control substrate serving as a heavy electrical substrate can be separated from each other via the third substrate 160. Therefore, influence of noise due to the control substrate 150 on the light electrical devices can be suppressed.

In addition, besides the smoothing capacitor 40, the third substrate 160 is interposed between the power module 110 and the first substrate 130. Therefore, influence of noise or heat of the power module 110 on the light electrical devices mounted on the first substrate 130 can be suppressed.

Next, a power conversion apparatus 50 according to a fifth embodiment of this invention is described.

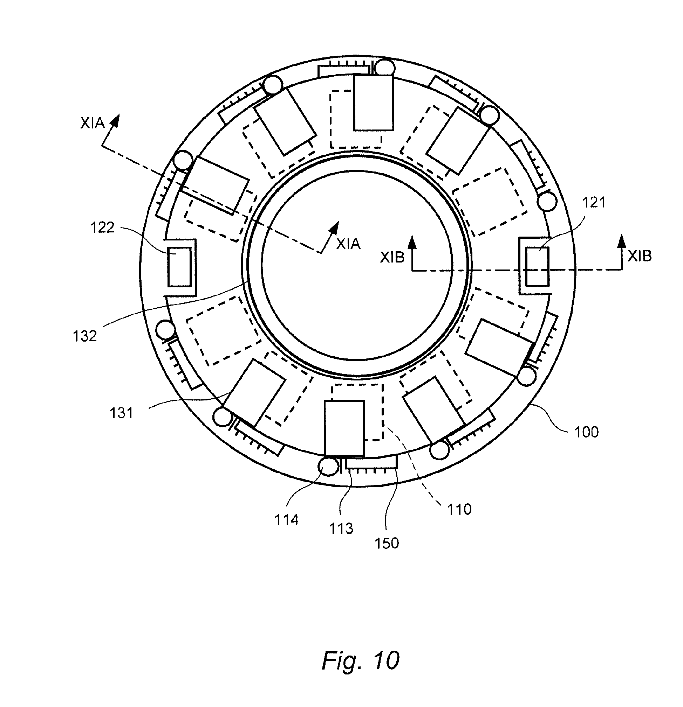

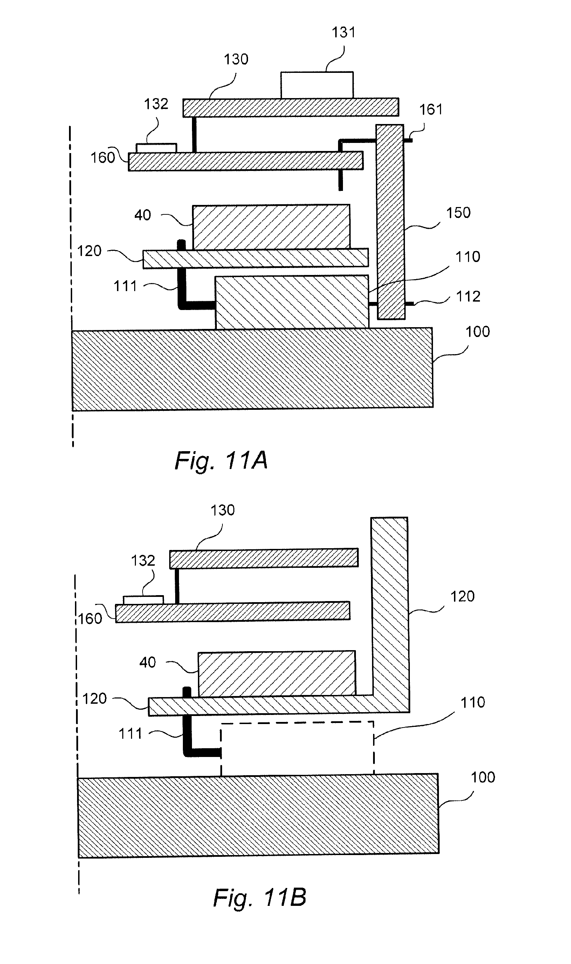

FIG. 10, FIG. 11A, and FIG. 11B are explanatory diagrams of the power conversion apparatus 50 according to the fifth embodiment of this invention. FIG. 10 is a top view of the power conversion apparatus 50. FIG. 11A is a cross-sectional view of the power conversion apparatus 50 taken along the line XIA-XIA in FIG. 10. FIG. 11B is a cross-sectional view of the power conversion apparatus 50 taken along the line XIB-XIB in FIG. 10.

Further, a basic structure of the fifth embodiment is the same as that of the first embodiment, and the same element as in the first to fourth embodiments is denoted by the same reference symbol so that overlapping description is omitted.

The fifth embodiment is a modified example of the fourth embodiment described above, and has a structure in which the current sensor 131 is mounted on the first substrate 130 and the pad 132 is mounted on the third substrate 160.

In the fifth embodiment, with this structure, the current sensor 131 that may be easily affected by noise or heat in particular can be separated from the control substrate 150. Further, the third substrate 160 is interposed between the power module 110 and the first substrate 130 in addition to the smoothing capacitor 40, and hence influence of noise or heat of the power module 110 on the current sensor 131 mounted on the first substrate 130 can be suppressed.

In addition, the position of the pad 132 can be changed, and hence connectivity to the driving motor M can be improved.

Next, a power conversion apparatus 50 according to a sixth embodiment of this invention is described.

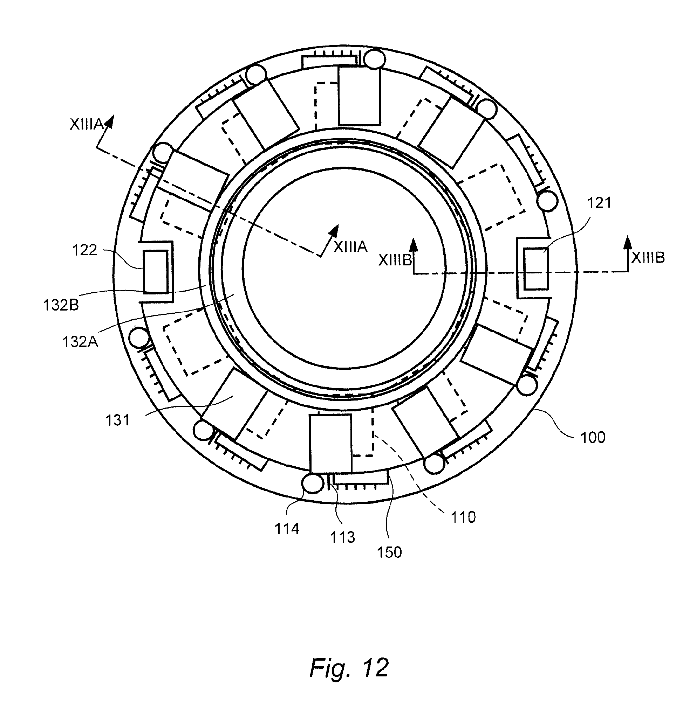

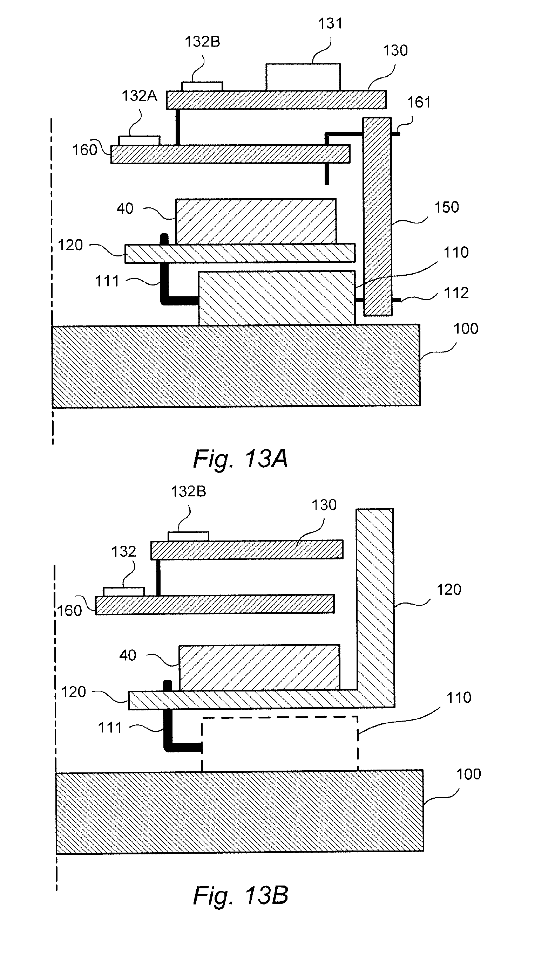

FIG. 12, FIG. 13A, and FIG. 13B are explanatory diagrams of the power conversion apparatus 50 according to the sixth embodiment of this invention. FIG. 12 is a top view of the power conversion apparatus 50. FIG. 13A is a cross-sectional view of the power conversion apparatus 50 taken along the line XIIIA-XIIIA in FIG. 12. FIG. 13B is a cross-sectional view of the power conversion apparatus 50 taken along the line XIIIB-XIIIB in FIG. 12.

Further, a basic structure of the sixth embodiment is the same as that of the first embodiment, and the same element as in the first to fifth embodiments is denoted by the same reference symbol so that overlapping description is omitted.

The sixth embodiment is a modified example of the fourth and fifth embodiments described above, and has a structure in which the current sensor 131 is mounted on the first substrate 130, and a first pad 132A and a second pad 132B are mounted on the first substrate 130 and the third substrate 160, respectively.

In the sixth embodiment, the different pads 132 are arranged on the plurality of substrates in this way, and hence the degree of freedom of wiring the signal line is improved, and connectivity to the driving motor M can be improved.

Next, a power conversion apparatus 50 according to a seventh embodiment of this invention is described.

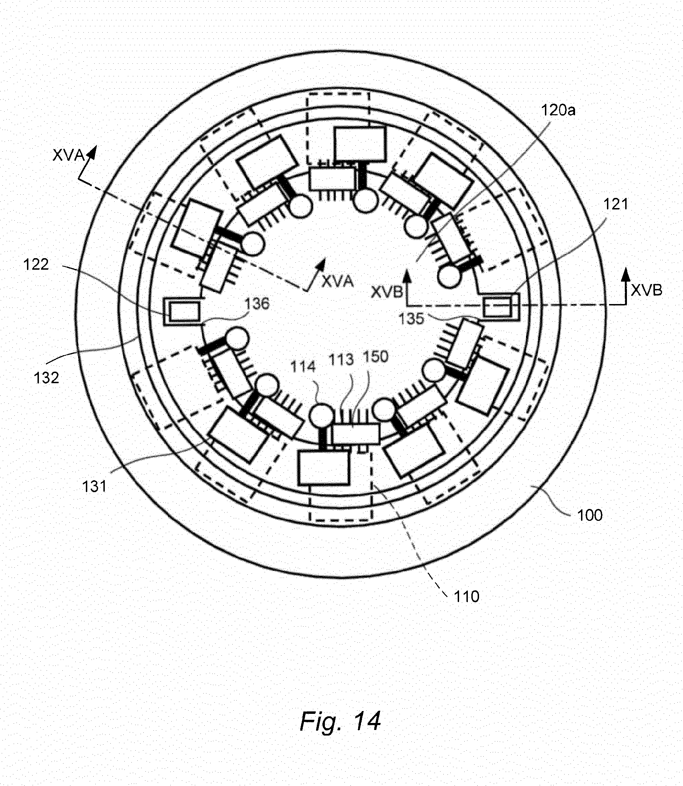

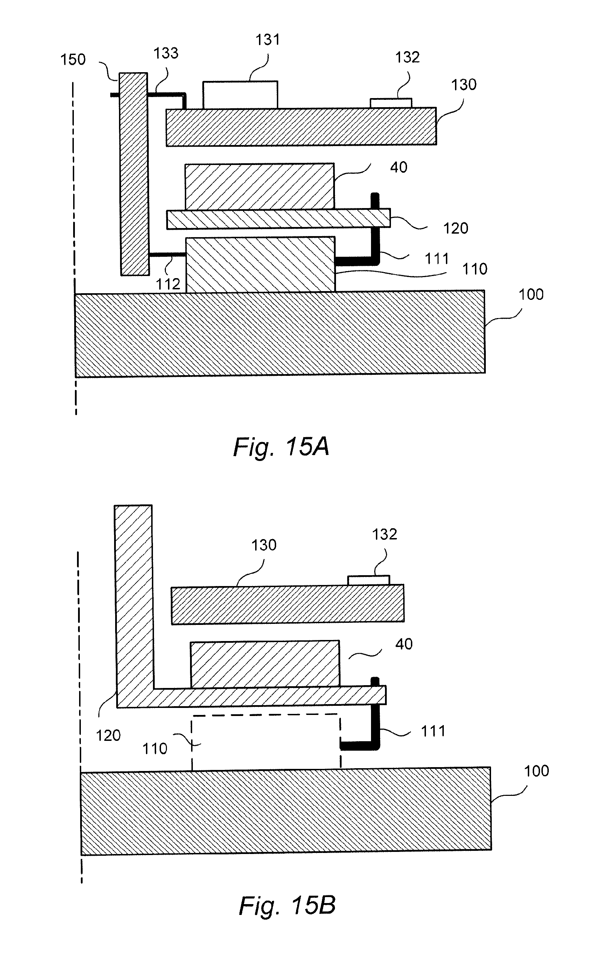

FIG. 14, FIG. 15A, and FIG. 15B are explanatory diagrams of the power conversion apparatus 50 according to the seventh embodiment of this invention. FIG. 14 is a top view of the power conversion apparatus 50. FIG. 15A is a cross-sectional view of the power conversion apparatus 50 taken along the line XVA-XVA in FIG. 14. FIG. 15B is a cross-sectional view of the power conversion apparatus 50 taken along the line XVB-XVB in FIG. 14.

Further, a basic structure of the seventh embodiment is the same as that of the first embodiment, and the same element as in the first to sixth embodiments is denoted by the same reference symbol so that overlapping description is omitted.

The seventh embodiment is different from the first to sixth embodiments described above in that the power module 110 is placed on the upper surface of the cooler 100 so that the AC bus bar 114 and the control signal terminals 113 are on the inner circumferential side while the PN terminals 111 are on the outer circumferential side. Ten power modules 110 are placed along the circular shape of the top of the cooler 100 at a predetermined interval along the circumferential direction.

The control substrates 150 are respectively arranged correspondingly to positions of the power modules 110 on the inner circumferential side of the circle on which the power modules 110 are arranged.

The DC bus bar 120 is arranged on the upper side of the power module 110, and the pins 121 and 122 are arranged to extend upward at two positions on the inner circumferential side of the annular DC bus bar 120.

The first substrate 130 is arranged on the upper side of the DC bus bar 120, and the cutout portions 135 and 136 for avoiding contact with the pins 121 and 122 of the DC bus bar 120 are formed at two positions on the inner circumferential side of the first substrate 130. The pad 132 arranged on the first substrate 130 is arranged in an annular shape on the outer circumferential side of the first substrate 130.

The AC bus bar 114 extending upward from the power module 110 extends upward from the circular hollow portion 120a on the inner circumferential side of the DC bus bar 120 and the first substrate 130. Similarly, the pins 121 and 122 of the DC bus bar 120 also extend upward from the circular hollow portion 120a on the inner circumferential side of the DC bus bar 120 and the first substrate 130.

Along this hollow portion 120a, the lower side of the control substrate 150 is fixed to the control signal terminals 113 of the power module 110 while the upper side of the control substrate 150 is fixed to the signal terminals 133 of the first substrate 130.

In the seventh embodiment, in this way, the AC bus bar 114 and the DC bus bar 120 extend upward from the inner circumferential side, while the pad 132 connected to the signal line of the driving motor M is arranged on the outer circumferential side. With this structure, the degree of freedom of wiring the signal line connected to the DC bus bar 120, the AC bus bar 114, and the pad 132 is improved, and connectivity to the driving motor M can be improved.

Next, a power conversion apparatus 50 according to an eighth embodiment of this invention is described.

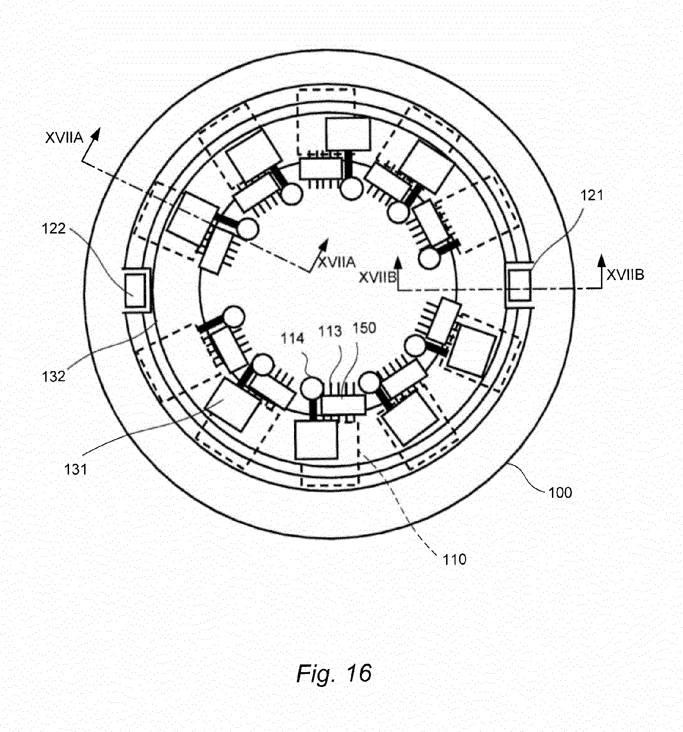

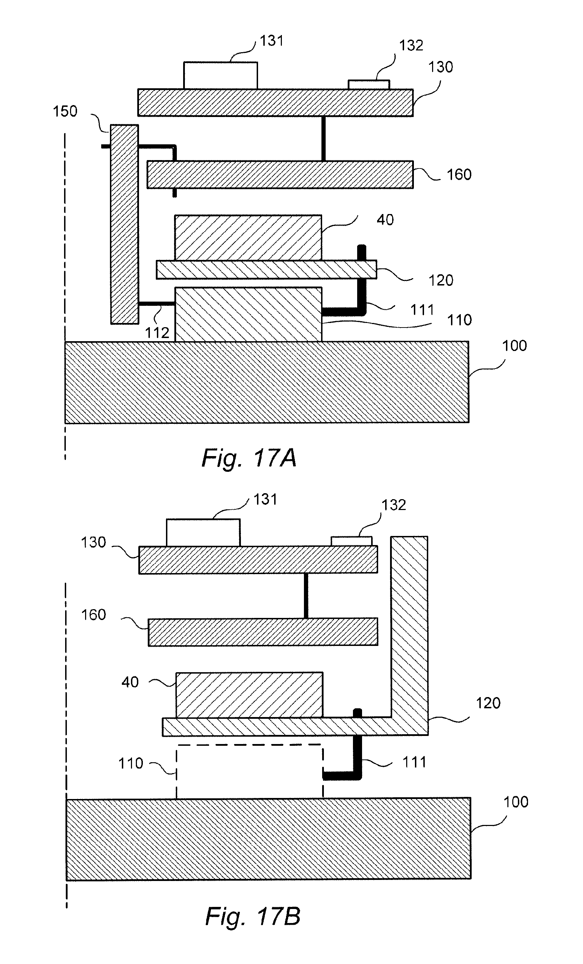

FIG. 16, FIG. 17A, and FIG. 17B are explanatory diagrams of the power conversion apparatus 50 according to the eighth embodiment of this invention. FIG. 16 is a top view of the power conversion apparatus 50. FIG. 17A is a cross-sectional view of the power conversion apparatus 50 taken along the line XVIIA-XVIIA in FIG. 16. FIG. 17B is a cross-sectional view of the power conversion apparatus 50 taken along the line XVIIB-XVIIB in FIG. 16.

Further, a basic structure of the eighth embodiment is the same as that of the first embodiment, and the same element as in the first to seventh embodiments is denoted by the same reference symbol so that overlapping description is omitted.

The eighth embodiment is a modified example of the seventh embodiment described above. The control substrates 150 are arranged on the inner circumferential side of the circle on which the power modules 110 are arranged, and the AC bus bar 114 is arranged to extend upward on the inner circumferential side.

Further, in the eighth embodiment, similarly to the fourth embodiment described above, in addition to the substrate 130 on which the current sensor 131 and the pad 132 are mounted, the third substrate 160 is further arranged for connecting the signals of the current sensor 131 and the pad 132 to the control substrate 150.

The control substrate 150 is arranged along the circular hollow portion 120a on the inner circumferential side of the DC bus bar 120 and the first substrate 130 so that the lower side thereof is fixed to the control signal terminals 113 of the power module 110 while the upper side thereof is fixed to the third substrate 160.

In the eighth embodiment, the pins 121 and 122 of the DC bus bar 120 and the cutout portions 134 and 135 of the first substrate 130 are arranged on the outer circumferential side but may be arranged on the inner circumferential side as in the seventh embodiment described above.

In the eighth embodiment, because the third substrate 160 is provided besides the first substrate 130 in this way, the effect similar to that of the fourth embodiment can be obtained in addition to the effect of the seventh embodiment described above.

Next, a power conversion apparatus 50 according to a ninth embodiment of this invention is described.

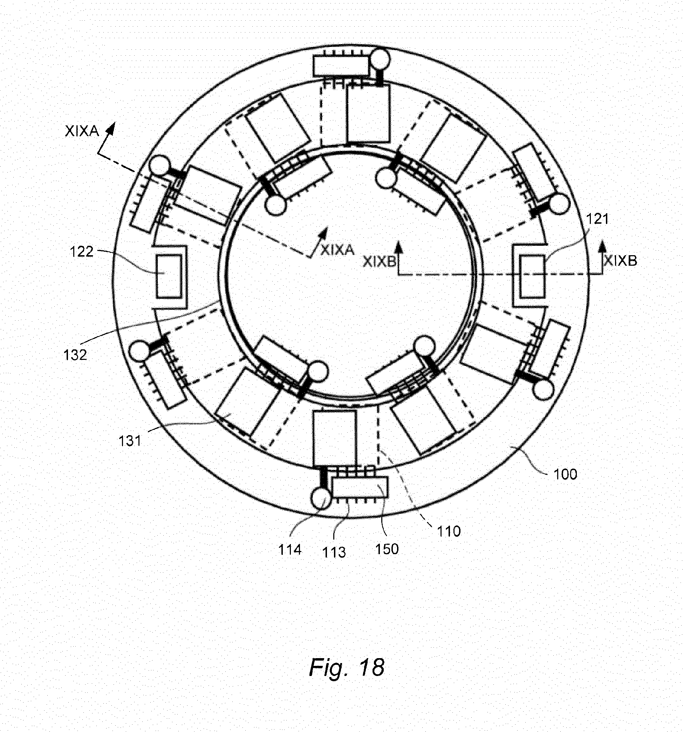

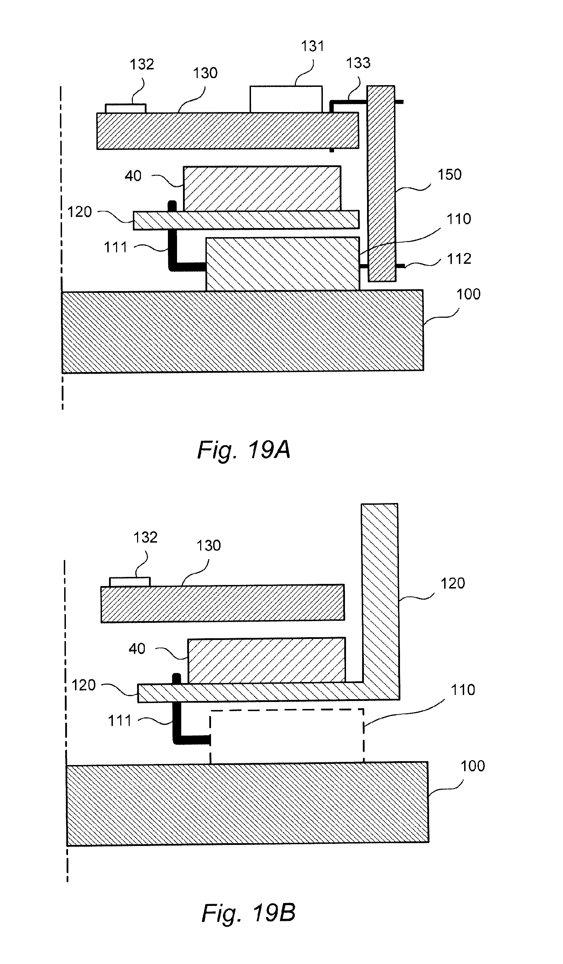

FIG. 18, FIG. 19A, and FIG. 19B are explanatory diagrams of the power conversion apparatus 50 according to the ninth embodiment of this invention. FIG. 18 is a top view of the power conversion apparatus 50. FIG. 19A is a cross-sectional view of the power conversion apparatus 50 taken along the line XIXA-XIXA in FIG. 18. FIG. 19B is a cross-sectional view of the power conversion apparatus 50 taken along the line XIXB-XIXIB in FIG. 18.

Further, a basic structure of the ninth embodiment is the same as that of the first embodiment, and the same element as in the first to eighth embodiments is denoted by the same reference symbol so that overlapping description is omitted.

The ninth embodiment is a modified example of the seventh embodiment. The power modules 110 are placed on the upper surface of the cooler 100 so as to have different directions alternately. In other words, the power module 110 whose AC bus bar 114 and control signal terminals 113 are on the inner circumferential side and the power modules 110 whose AC bus bar 114 and control signal terminals 113 are on the outer circumferential side are arranged alternately.

Further, the pins 121 and 122 of the DC bus bar 120 and the cutout portions 134 and 135 of the first substrate 130 are arranged on the outer circumferential side in the ninth embodiment but may be arranged on the inner circumferential side as in the seventh embodiment described above.

In the ninth embodiment, the AC bus bar 114 extends upward from the inner circumferential side in this way. With this structure, the degree of freedom of wiring the signal line or the like connected to the DC bus bar 120, the AC bus bar 114, and the pad 132 is improved, and hence connectivity to the driving motor M can be improved.

Further, the embodiments of this invention described above are merely examples of the structure embodying this invention, and this structure is not intended to be interpreted as a limitation. In addition, the structures of the first to ninth embodiments may be combined.

In addition, in the embodiments of this invention, description has been given of the power conversion apparatus 50 including the power semiconductor 31 and the diode 32 so as to form the inverter, but this structure is not a limitation. The embodiments described above can be applied similarly to a semiconductor device including a semiconductor element, and a control substrate and a light electrical substrate relating to operation of the semiconductor element.

In addition, in the embodiments of this invention described above, the control substrate 150 may be formed of a flexible substrate having flexibility.

Though a description has been given of the embodiments of this invention, the embodiments describe only a part of application examples of this invention, and are not intended to limit the technical scope of this invention to the specific configurations of the above-mentioned embodiments.

This application claims priority from Japanese Patent Application No. 2012-50627, filed with the Japan Patent Office on March 7, 2012, all the contents of which are hereby incorporated by reference.

Exclusive nature or features of the embodiments of this invention are claimed as follows.

## Claims

1. A power conversion apparatus, comprising:
a power module including a power semiconductor;
a base section including a cooler adapted to cool the power module;
a second substrate, on which a control circuit adapted to control the power module is mounted;
a first bus bar adapted to supply power to the power module;
a second bus bar adapted to output power from the power module;
a smoothing capacitor adapted to smooth power of the first bus bar; and
a first substrate including a signal wiring,
wherein the power module is placed on an upper surface of the base section,
wherein the first bus bar, the smoothing capacitor, and the first substrate are sequentially stacked on an upper side of the power module, and
wherein the second substrate is arranged in an upright direction with respect to the base section and is fixed to the power module and the first substrate.

2. The power conversion apparatus according to claim 1, further comprising a third substrate including a current detecting portion adapted to detect a current of the second bus bar,
wherein the first bus bar includes a pin extending upward, and
wherein the third substrate has a cutout portion formed at a position corresponding to the pin.

3. The power conversion apparatus according to claim 1 or 2, wherein the smoothing capacitor is mounted on the first bus bar and is arranged between the power module and the first substrate.

4. The power conversion apparatus according to any one of claims 1 to 3,
wherein the first substrate or the third substrate includes a connecting portion to which a signal line is connected adapted to send and receive a signal to and from an external apparatus, and
wherein the connecting portion is arranged on an outer circumferential side or an inner circumferential side of the first substrate or the third substrate.
